# EUROPEAN PATENT APPLICATION

(11) **EP 4 369 892 A1**
(43) Date of publication of application: **15.05.2024**
(21) Application number: 22857649.2
(22) Date of filing: 09.08.2022
(51) Int. Cl.: H10K 59/00, H05K 9/00, H05K 7/20

(54) **DISPLAY MODULE AND ELECTRONIC DEVICE**

(30) Priority: 17.08.2021 CN 202110944272
(71) Applicant: Huawei Technologies Co., Ltd., Shenzhen, Guangdong 518129 (CN)
(72) Inventor: LAO, Xun, Shenzhen, Guangdong 518129 (CN); SHEN, Menghu, Shenzhen, Guangdong 518129 (CN); HAN, Haisu, Shenzhen, Guangdong 518129 (CN); LI, Xia, Shenzhen, Guangdong 518129 (CN); TENG, Zhaoyu, Shenzhen, Guangdong 518129 (CN); DAI, Xiaotao, Shenzhen, Guangdong 518129 (CN)
(74) Representative: Gill Jennings & Every LLP
(86) International application number: PCT/CN2022/111237
(87) International publication number: WO 2023/020337

(57) **Abstract**

This application provides a display assembly and an electronic device. The display assembly includes: a display panel, a polarizer, and a heat dissipation film. The display panel includes a substrate and a plurality of light emitting devices located on a side of the substrate. The polarizer is located on a side of the light emitting device away from the substrate. The heat dissipation film is located on a side of the display panel away from the polarizer. The polarizer includes at least one electrostatic dissipation layer, or the heat dissipation film includes at least one electrostatic dissipation layer. The electrostatic dissipation layer is configured to guide static electricity into the electrostatic dissipation layer. This application can resolve a problem in the conventional technology that a display fault is caused because a display assembly is likely to be shocked by static electricity, and improve an anti-static capability of the display assembly.

## Description

This application claims priority to Chinese Patent Application No. 202110944272.7, filed with the China National Intellectual Property Administration on August 17, 2021 and entitled "DISPLAY ASSEMBLY AND ELECTRONIC DEVICE", which is incorporated herein by reference in its entirety.

### TECHNICAL FIELD

This application relates to the field of display technologies, and more specifically, to a display assembly and an electronic device.

### BACKGROUND

An organic light-emitting diode (OLED, Organic Light-Emitting Diode) has become a mainstream display technology of a next generation due to features of low power consumption, high contrast, wide color gamut, high response speed, self-luminescent, and the like. In addition, because of the self-luminescent feature of the organic light-emitting diode, a thin display assembly can be made, and this makes it possible to make flexible products such as a foldable product and a rollable product. An existing product is affected by static electricity to a specific extent during assembly and use of a whole machine. A shock is caused by discharging the static electricity, and an instantaneous high voltage or charge accumulation is formed inside a display screen. A failure clearly occurs on an electronic device in a serious case, and consequently an unrecoverable fault is caused.

### SUMMARY

In view of this, this application provides a display assembly and an electronic device, to resolve a problem in the conventional technology that a display fault is caused because a display assembly is likely to be shocked by static electricity, and improve an anti-static capability of the display assembly.

According to a first aspect, an embodiment of this application provides a display assembly, where the display assembly includes a display panel, a polarizer, and a heat dissipation film. The display panel includes a substrate and a plurality of light emitting devices located on a side of the substrate. The polarizer is located on a side of the light emitting device away from the substrate. The heat dissipation film is located on a side of the display panel away from the polarizer. The polarizer includes at least one electrostatic dissipation layer, or the heat dissipation film includes at least one electrostatic dissipation layer. The electrostatic dissipation layer is configured to guide static electricity into the electrostatic dissipation layer.

In this embodiment of this application, the electrostatic dissipation layer can be configured to guide the static electricity into the electrostatic dissipation layer, to avoid a case in which the static electricity is transmitted from a back side of the display panel to an array layer, and avoid a display fault caused by electrostatic accumulation. In this application, an anti-static capability of the display assembly is improved without removing an anti-fingerprint coating in the display assembly, thereby ensuring a display effect of the display assembly and a smooth touch feeling of a user.

In some implementations, the polarizer includes at least one electrostatic dissipation layer. The polarizer is located on a side of a display screen of the display panel, and setting the polarizer to include at least one electrostatic dissipation layer is equivalent to adding an electrostatic dissipation layer with low impedance on a path through which static electricity is transmitted to the display panel. After electrostatic charges are generated on a surface of a cover plate of the display assembly due to friction, when the electrostatic charges are transmitted from the cover plate to the inside of the display assembly, the static electricity is first conducted into the electrostatic dissipation layer, to block transmission of the electrostatic charges and avoid a case in which the static electricity is transmitted to a back side of the display panel. In this way, a case in which the static electricity is accumulated on the back side of the display panel and is transmitted from the back side of the display panel to an array layer is avoided, and a risk of a display fault caused by electrostatic accumulation is reduced.

In some other implementations, the heat dissipation film includes at least one electrostatic dissipation layer. In the display assembly, the heat dissipation film is in contact with a support film, and the electrostatic dissipation layer is disposed on the heat dissipation film. A path for discharging static electricity is formed on a back side of the display panel, so that static electricity transmitted to the support film can be conducted into the electrostatic dissipation layer, in other words, the static electricity on the support film can be quickly discharged, to avoid electrostatic accumulation on the support film. In this way, electrostatic charge accumulation on the back side of the display panel can be avoided, and a display fault caused by electrostatic accumulation on the display panel is avoided, thereby improving an anti-static capability of the display assembly.

In some implementations, surface impedance of the electrostatic dissipation layer is Z, where Z≤E11 Ω/sq. The electrostatic dissipation layer is a low-impedance layer with low impedance and can guide static electricity into the electrostatic dissipation layer.

In some implementations, the polarizer includes a polarizing function layer and a pressure-sensitive adhesive layer, and at least one pressure-sensitive adhesive layer is doped with a conductive material, and is used as the electrostatic dissipation layer. In this implementation, the pressure-sensitive adhesive layer is doped with the conductive material to reduce surface impedance of the pressure-sensitive adhesive layer, to enable the polarizer to be a low-impedance polarizer. When static electricity is transmitted from a cover plate to the module, the static electricity can be conducted into the polarizer, to block transmission of the static electricity to a back side of the display panel.

In some implementations, the electrostatic dissipation layer is located between a polarizing function layer and a pressure-sensitive adhesive layer. In this implementation, a low-impedance conductive layer is added between the polarizing function layer and the pressure-sensitive adhesive layer, and is used as the electrostatic dissipation layer, to enable the polarizer to be a low-impedance polarizer. When static electricity is transmitted from a cover plate to the module, the static electricity can be conducted into the polarizer, to block transmission of the static electricity to a back side of the display panel.

In some implementations, the heat dissipation film includes a reticulate adhesive layer, a foam layer, and a heat dissipation function layer that are successively away from the display panel. The reticulate adhesive layer is doped with a conductive material, and the reticulate adhesive layer is used as the electrostatic dissipation layer. The reticulate adhesive layer is doped with the conductive material to form a reticulate adhesive layer with low impedance, so that charges on an interface of the support film can be conducted into the reticulate adhesive layer, and the charges on the interface of the support film can be quickly discharged, to avoid charge accumulation on the support film. In this way, charge accumulation on a back side of the display panel is avoided, thereby avoiding a display fault caused by charge accumulation.

In some implementations, the foam layer is doped with a conductive material, and the foam layer is used as the electrostatic dissipation layer. In this implementation, charges on an interface of a support film can be conducted into the reticulate adhesive layer, and then the charges are conducted into the foam layer through the reticulate adhesive layer, so that the charges on the interface of the support film can be quickly discharged, to avoid charge accumulation on the support film. In this way, charge accumulation on a back side of the display panel is avoided, thereby avoiding a display fault caused by charge accumulation.

In some implementations, a first adhesive layer is further disposed between the foam layer and the heat dissipation function layer, the first adhesive layer is doped with a conductive material, and the first adhesive layer is used as the electrostatic dissipation layer. In this implementation, the reticulate adhesive layer, the foam layer, and the first adhesive layer between the foam layer and the heat dissipation function layer are all electrostatic dissipation layers with low impedance, and a path for discharging static electricity is formed on a back side of the display panel. Static electricity on an interface of a support layer can be conducted into the reticulate adhesive layer, conducted into the foam layer through the reticulate adhesive layer, conducted into the first adhesive layer through the foam layer, and then conducted into the heat dissipation function layer through the first adhesive layer. The heat dissipation function layer is grounded or connected to a middle frame of an electronic device, so that electrostatic charges on the back side of the display panel can be quickly discharged. In this way, charge accumulation on the back side of the display panel is avoided, thereby avoiding a display fault caused by charge accumulation.

In some implementations, the display assembly further includes a first conductive structure. The first conductive structure covers at least a part of an end portion of the heat dissipation film. The first conductive structure extends from an end face of the reticulate adhesive layer to an end face of the heat dissipation function layer. The first conductive structure can implement a conductive path between the reticulate adhesive layer and the heat dissipation function layer. In this implementation, a path that is for discharging static electricity and that can be formed on a back side of the display panel is as follows: Static electricity on an interface of a support layer can be conducted into the reticulate adhesive layer, and conducted into the heat dissipation function layer by using the first conductive structure covering the end face of the reticulate adhesive layer. The heat dissipation function layer is grounded or connected to a middle frame of an electronic device, so that electrostatic charges on the back side of the display panel can be quickly discharged. In this way, charge accumulation on the back side of the display panel is avoided, thereby avoiding a display fault caused by charge accumulation.

According to a second aspect, an embodiment of this application provides another display assembly, where the display assembly includes:
a display panel, where the display panel includes a substrate and a plurality of light emitting devices located on a side of the substrate;
a support film, where the support film is located on a side of the substrate away from the light emitting device, and a surface on a side of the support film away from the substrate is a first surface; and
a heat dissipation film, where the heat dissipation film is located on a side of the support film away from the substrate, a surface on a side of the heat dissipation film away from the support film is a second surface, the heat dissipation film has an opening groove, and the opening groove exposes the first surface, where
the display assembly further includes a second conductive structure, and the second conductive structure covers the first surface and extends to cover a side wall of the opening groove and at least a part of the second surface.

The opening groove is provided on the heat dissipation film, the opening groove exposes the surface of the support film, and then the continuous second conductive structure is coated on the exposed surface of the support film, the side wall of the opening groove, and a back side of the heat dissipation film to form a path for discharging static electricity, so that static electricity on the support film can be quickly discharged, thereby avoiding electrostatic accumulation on the support film. With a design of the opening groove, a contact area between the second conductive structure and the support film is increased, and a contact area between the second conductive structure and the heat dissipation film is also increased, so that a conductive channel between the support film and the second conductive structure is wider, and a capability for discharging static electricity can be enhanced. In this way, static electricity on a back side of the display panel can be quickly discharged by using the second conductive structure, thereby avoiding electrostatic accumulation on the back side of the display panel. In addition, an anti-static capability of the display assembly is improved without removing an anti-fingerprint coating in the display assembly, thereby ensuring a display effect of the display assembly and a smooth touch feeling of a user.

In addition, with the design of the opening groove, three surfaces including the first surface of the support film, the side wall (which is equivalent to a side face of the heat dissipation film) of the opening groove, and the second surface of the heat dissipation film are connected by using the second conductive structure, and an overall connection effect is good. In addition, both contact areas between the second conductive structure and the first surface and between the second conductive structure and the second surface are large, so that a problem that a conductive path is blocked due to solidification cracking caused by conductive liquid being coated only on end faces of the support film and the heat dissipation film can be avoided.

In some implementations, a part of an edge of the heat dissipation film is recessed to the inside of the heat dissipation film to form the opening groove. A process for forming the opening groove at the edge of the heat dissipation film is simple, a range in which the second conductive structure can be disposed is large, and an overall structure of the display assembly is slightly affected.

In some implementations, the heat dissipation film includes a first end portion and a second end portion. In a first direction, the first end portion and the second end portion are respectively located on two sides of the display assembly. A quantity of opening grooves formed at the first end portion is equal to a quantity of opening grooves formed at the second end portion. In this way, it is beneficial to balance capabilities for discharging static electricity at various positions of a back side of the display panel and avoid local electrostatic accumulation.

In some implementations, the display assembly further includes a cover plate, and the cover plate is located on a side of the display panel away from the support film. The second conductive structure further extends from the first surface to cover an end face of the display panel and an end face of the cover plate. The second conductive structure can implement a conductive path between the cover plate and the heat dissipation film, and electrostatic charges generated on a surface of the cover plate due to friction can be directly conducted into the heat dissipation film by using the second conductive structure, to avoid electrostatic accumulation caused by transmission of static electricity to a back side of the display panel.

In this embodiment of this application, the heat dissipation film includes a reticulate adhesive layer, a foam layer, and a heat dissipation function layer that are successively away from the support film.

In some implementations, at a position of the opening groove, end faces of the reticulate adhesive layer, the foam layer, and the heat dissipation function layer are flush. In this way, a process for forming the opening groove of the heat dissipation film is relatively simple.

In some implementations, at a position of the opening groove, an end face of the foam layer extends out of an end face of the heat dissipation function layer, and an end face of the reticulate adhesive layer extends out of the end face of the foam layer. In this way, when the second conductive structure is coated at a side wall position of the opening groove, it can be ensured that the second conductive structure extends from the first surface to the second surface in a relatively smooth way, to improve reliability of covering the side wall of the opening groove by the second conductive structure.

In some implementations, at a position of the opening groove, an end face of the reticulate adhesive layer is flush with an end face of the foam layer, and an end face of the heat dissipation function layer extends out of the end face of the foam layer. In this way, a contact area between the second conductive structure and the heat dissipation function layer can be further increased.

According to a third aspect, another embodiment of this application provides an electronic device, including the display assembly provided in any embodiment of this application.

The display assembly and the electronic device that are provided in this application have the following beneficial effects. In some implementations, an electrostatic dissipation layer is disposed in the display assembly. The electrostatic dissipation layer can be configured to guide static electricity into the electrostatic dissipation layer, to avoid a case in which the static electricity is transmitted from a back side of a display panel to an array layer, and avoid a display fault caused by electrostatic accumulation. In some implementations, an opening groove is provided on a heat dissipation film, the opening groove exposes a surface of a support film, and then a continuous second conductive structure is coated on the exposed surface of the support film, a side wall of the opening groove, and a back side of the heat dissipation film to form a path for discharging static electricity, so that static electricity on the support film can be quickly discharged, thereby avoiding electrostatic accumulation on the support film. In this application, an anti-static capability of the display assembly is improved without removing an anti-fingerprint coating in the display assembly, thereby ensuring a display effect of the display assembly and a smooth touch feeling of a user.

### BRIEF DESCRIPTION OF DRAWINGS

FIG. 1 is a schematic top view of a display assembly according to an embodiment of this application;
FIG. 2 is a schematic cross sectional view of a position of a tangent A-A' in FIG. 1;
FIG. 3 is a schematic diagram of another display assembly according to an embodiment of this application;
FIG. 4 is a schematic diagram of a structure of a polarizer in another display assembly according to an embodiment of the present invention;
FIG. 5 is a schematic diagram of a structure of a polarizer in another display assembly according to an embodiment of the present invention;
FIG. 6 is a schematic diagram of a structure of a polarizer in another display assembly according to an embodiment of the present invention;
FIG. 7 is a schematic diagram of another display assembly according to an embodiment of this application;
FIG. 8 is a schematic diagram of another display assembly according to an embodiment of this application;
FIG. 9 is a schematic diagram of another display assembly according to an embodiment of this application;
FIG. 10 is a schematic diagram of another display assembly according to an embodiment of this application;
FIG. 11 is a schematic diagram of another display assembly according to an embodiment of this application;
FIG. 12 is a schematic diagram of another display assembly according to an embodiment of this application;
FIG. 13 is a schematic cross sectional view of a position of a tangent B-B' in FIG. 12;
FIG. 14 is a schematic diagram of another display assembly according to an embodiment of this application;
FIG. 15 is a schematic diagram of another display assembly according to an embodiment of this application;
FIG. 16 is a schematic diagram of another display assembly according to an embodiment of this application;
FIG. 17 is a schematic diagram of another display assembly according to an embodiment of this application; and
FIG. 18 is a schematic diagram of an electronic device according to an embodiment of this application.

### DESCRIPTION OF EMBODIMENTS

In the conventional technology, an anti-fingerprint coating is disposed on a surface of a display assembly, and a main component of the anti-fingerprint coating is perfluoropolyether, which includes a high concentration of fluorine. The fluorine has a strong electron withdrawing capability, so that negative charges are accumulated due to friction in a use process of an electronic product. When the negative charges are transmitted to a module of a display panel, a structure in the module is shocked by static electricity, and a display failure is caused in a serious case. In the conventional technology, a solution for resolving a problem of the static electricity shock is to remove the anti-fingerprint coating. In this way, a source of generation of frictional static electricity can be eliminated, and the problem of the static electricity shock does not occur. However, the anti-fingerprint coating has an oleophobic function, and the anti-fingerprint coating can improve a smooth feeling when a user touches the surface of the display assembly and slides on the surface by using fingers. If the anti-fingerprint coating is removed, user experience of the electronic product is poor, and grease is likely to be accumulated on the surface of the display panel. This affects a display effect.

Based on this, embodiments of this application provide a display assembly, to improve an anti-static capability of the display assembly, and reduce a risk of a display failure caused by a static electricity shock.

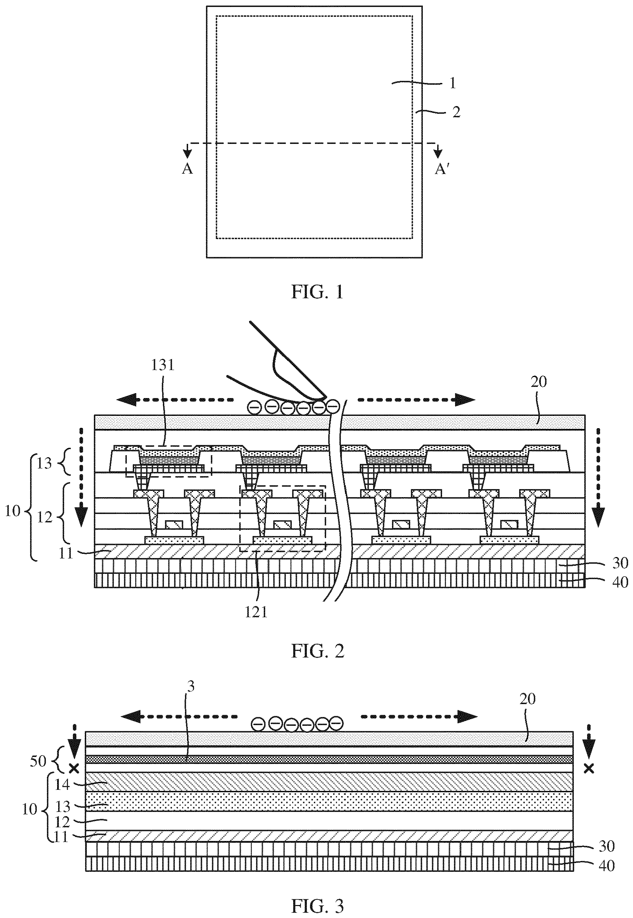

FIG. 1 is a schematic top view of a display assembly according to an embodiment of this application. FIG. 2 is a schematic cross sectional view of a position of a tangent A-A' in FIG. 1. As shown in FIG. 1, the display assembly includes a display region 1 and a non-display region surrounding the display region 1. As shown in FIG. 2, the display assembly includes a display panel 10, a cover plate 20 located on a side of a display screen of the display panel 10, and a support film 30 and a heat dissipation film 40 that are located on a back side of the display panel 10. The display panel 10 includes a substrate 11, and an array layer 12 and a display layer 13 that are located on the substrate 11, where the array layer 12 includes a plurality of transistors 121, and the display layer 13 includes a plurality of light emitting devices 131. A light emitting region formed by the plurality of light emitting devices 131 is the display region 1. In an embodiment, the light emitting device 131 is an organic light emitting device. In another embodiment, the light emitting device 131 is an inorganic light emitting device.

In an embodiment, the cover plate 20 is a glass cover plate, and the cover plate 20 is configured to protect the display panel 10 on the side of the display screen of the display panel 10.

FIG. 2 shows a transmission path of negative charges accumulated on a surface of the cover plate 20 in the display assembly. It can be seen that the negative charges accumulated on the surface of the cover plate 20 due to friction are transmitted downward along an edge of the module. A pixel circuit and a peripheral circuit are disposed in the array layer 12, and structures of the circuits are close to the support film 30. When static electricity is transmitted to the support film 30 and is accumulated, the static electricity enters the array layer 12 through an interface on which the support film 30 is in contact with the display panel 10. Consequently, circuit performance in the array layer 12 is affected, a shock caused by discharging the static electricity causes a display failure, and an unrecoverable fault is caused in a serious case.

In some implementations, an electrostatic dissipation layer is disposed in the display assembly, and an orthogonal projection of the electrostatic dissipation layer on the display panel at least overlaps the display region, where the electrostatic dissipation layer is a low-impedance layer. In some implementations, surface impedance of the electrostatic dissipation layer is Z, where Z≤E11 Ω/sq. The electrostatic dissipation layer has low impedance, and the electrostatic dissipation layer can be configured to guide static electricity into the electrostatic dissipation layer, to avoid a case in which the static electricity is transmitted from the back side of the display panel to the array layer, and avoid a display fault caused by electrostatic accumulation. In this application, an anti-static capability of the display assembly is improved without removing an anti-fingerprint coating in the display assembly, thereby ensuring a display effect of the display assembly and a smooth touch feeling of a user.

In an embodiment, FIG. 3 is a schematic diagram of another display assembly according to an embodiment of this application. As shown in FIG. 3, the display assembly further includes a polarizer 50. The polarizer 50 is located on a side of a display layer 13 away from a substrate 11. To be specific, the polarizer 50 is located between a display panel 10 and a cover plate 20. The polarizer 50 includes at least one electrostatic dissipation layer 3. In the conventional technology, usually, surface impedance of a polarizer is about E13 S2/sq. In this embodiment of this application, the electrostatic dissipation layer 3 is disposed in the polarizer 50, so that surface impedance of the polarizer 50 is not greater than E11 Ω/sq. In this case, the polarizer 50 is a low-impedance polarizer. The polarizer 50 is located on a side of a display screen of the display panel 10, and this is equivalent to adding the electrostatic dissipation layer 3 with low impedance on a path through which static electricity is transmitted to the display panel 10. After electrostatic charges are generated on a surface of a cover plate 20 of the display assembly due to friction, when the electrostatic charges are transmitted from the cover plate 20 to the inside of the display assembly, static electricity is first conducted into the electrostatic dissipation layer 3, to block transmission of the electrostatic charges and avoid a case in which the static electricity is transmitted to a back side of the display panel. In this way, a case in which the static electricity is accumulated on the back side of the display panel and is transmitted from the back side of the display panel to an array layer is avoided, and a risk of a display fault caused by electrostatic accumulation is reduced.

As shown in FIG. 3, the display panel 10 further includes an encapsulation structure 14. The encapsulation structure 14 is located on a side of the display layer 13 away from the array layer 12. The encapsulation structure 14 is configured to encapsulate and protect a light emitting device 131, to ensure a service life of the light emitting device 131. In some implementations, the encapsulation structure 14 includes at least one inorganic encapsulation layer and at least one organic encapsulation layer.

In some implementations, the display panel 10 further includes a touch layer. The touch layer is located on a side of the encapsulation structure 14 away from the display layer 13, and the touch layer is configured to implement a touch function of the display assembly.

In some implementations, a film layer like an anti-fingerprint coating or an anti-glare layer is coated on a side of the cover plate 20 away from the display panel 10 provided in this embodiment of this application.

In an embodiment, the substrate 11 is a rigid substrate, for example, a glass substrate. In another embodiment, the substrate 11 is a flexible substrate, for example, a polyimide substrate.

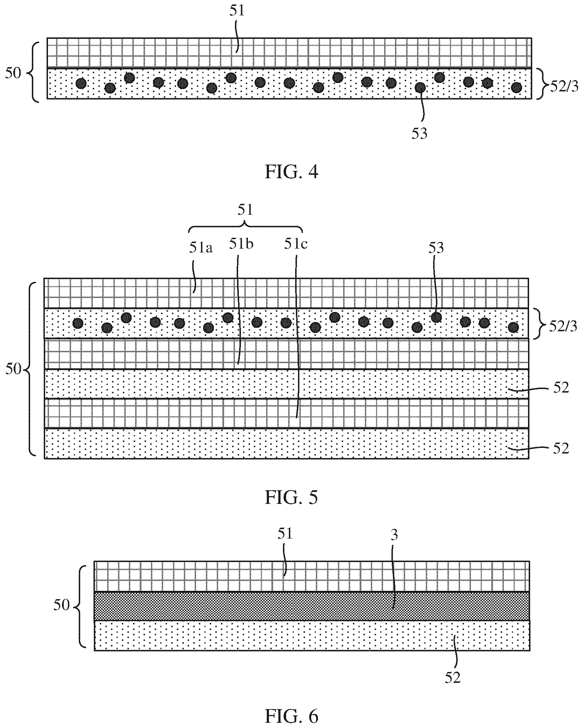

In some implementations, at least one pressure-sensitive adhesive layer in the polarizer is doped with a conductive material, and is used as the electrostatic dissipation layer. FIG. 4 is a schematic diagram of a structure of a polarizer in another display assembly according to an embodiment of the present invention. As shown in FIG. 4, the polarizer 50 includes a polarizing function layer 51 and a pressure-sensitive adhesive layer 52. The pressure-sensitive adhesive layer 52 is doped with a conductive material 53, and is used as an electrostatic dissipation layer 3. That is, the pressure-sensitive adhesive layer 52 is reused as the electrostatic dissipation layer 3. In this implementation, the pressure-sensitive adhesive layer is doped with the conductive material to reduce surface impedance of the pressure-sensitive adhesive layer 52, to enable the polarizer 50 to be a low-impedance polarizer. When static electricity is transmitted from a cover plate 20 to the module, the static electricity can be conducted into the polarizer 50, to block transmission of the static electricity to a back side of a display panel 10.

In some implementations, the conductive material 53 includes one or more of conductive materials such as 3,4-ethylenedioxythiophene monomer, PEDOT (a polymer of (3,4-ethylenedioxythiophene monomer)), fluorine, and phosphorus.

In some implementations, FIG. 5 is a schematic diagram of a structure of a polarizer in another display assembly according to an embodiment of the present invention. As shown in FIG. 5, a polarizing function layer 51 includes a first polarizing function layer 51a, a second polarizing function layer 51b, and a third polarizing function layer 51c that are disposed in a stacked manner. A pressure-sensitive adhesive layer 52 is disposed between every two adjacent polarizing function layers, and a pressure-sensitive adhesive layer 52 is also disposed on a side of the third polarizing function layer 51c away from the second polarizing function layer 51b. The pressure-sensitive adhesive layer 52 disposed on the side of the third polarizing function layer 51c away from the second polarizing function layer 51b is configured to implement adhesion between the polarizer 50 and a display panel 10. As shown in FIG. 5, the pressure-sensitive adhesive layer 52 between the first polarizing function layer 51a and the second polarizing function layer 51b is doped with a conductive material 53, and is used as an electrostatic dissipation layer 3.

In some implementations, the second polarizing function layer 51b is a polyvinyl alcohol film, and both the first polarizing function layer 51a and the third polarizing function layer 51c are cellulose triacetate films.

In another embodiment, the pressure-sensitive adhesive layer 52 between the second polarizing function layer 51b and the third polarizing function layer 51c is doped with a conductive material, and is reused as an electrostatic dissipation layer 3.

In another embodiment, the pressure-sensitive adhesive layer 52 disposed on the side of the third polarizing function layer 51c away from the second polarizing function layer 51b is doped with a conductive material, and is reused as an electrostatic dissipation layer 3.

In another embodiment, each pressure-sensitive adhesive layer 52 in the polarizer 50 is doped with a conductive material. In other words, the polarizer 50 includes a plurality of electrostatic dissipation layers 3.

In some implementations, FIG. 6 is a schematic diagram of a structure of a polarizer in another display assembly according to an embodiment of the present invention. As shown in FIG. 6, the polarizer 50 includes a polarizing function layer 51 and a pressure-sensitive adhesive layer 52. An electrostatic dissipation layer 3 is located between the polarizing function layer 51 and the pressure-sensitive adhesive layer 52. In this implementation, a low-impedance conductive layer is added between the polarizing function layer 51 and the pressure-sensitive adhesive layer 52, and is used as the electrostatic dissipation layer 3, to enable the polarizer 50 to be a low-impedance polarizer. When static electricity is transmitted from a cover plate 20 to the module, the static electricity can be conducted into the polarizer 50, to block transmission of the static electricity to a back side of a display panel 10.

Refer to the structure with three polarizing function layers shown in FIG. 5. In an embodiment, a low-impedance conductive layer is added between the first polarizing function layer 51a and the pressure-sensitive adhesive layer 52, and is used as an electrostatic dissipation layer. In another embodiment, a low-impedance conductive layer is added between the second polarizing function layer 51b and the pressure-sensitive adhesive layer 52, and is used as an electrostatic dissipation layer. In another embodiment, a low-impedance conductive layer is added between the third polarizing function layer 51c and the pressure-sensitive adhesive layer 52, and is used as an electrostatic dissipation layer.

In another embodiment, a heat dissipation film 40 includes at least one electrostatic dissipation layer 3. In the display assembly, the heat dissipation film 40 is in contact with a support film 30, and the electrostatic dissipation layer 3 is disposed on the heat dissipation film 40. A path for discharging static electricity is formed on the back side of the display panel 10, so that static electricity transmitted to the support film 30 can be conducted into the electrostatic dissipation layer 3, in other words, the static electricity on the support film 30 can be quickly discharged, to avoid electrostatic accumulation on the support film. In this way, electrostatic charge accumulation on the back side of the display panel 10 can be avoided, and a display fault caused by electrostatic accumulation on the display panel 10 is avoided, thereby improving an anti-static capability of the display assembly.

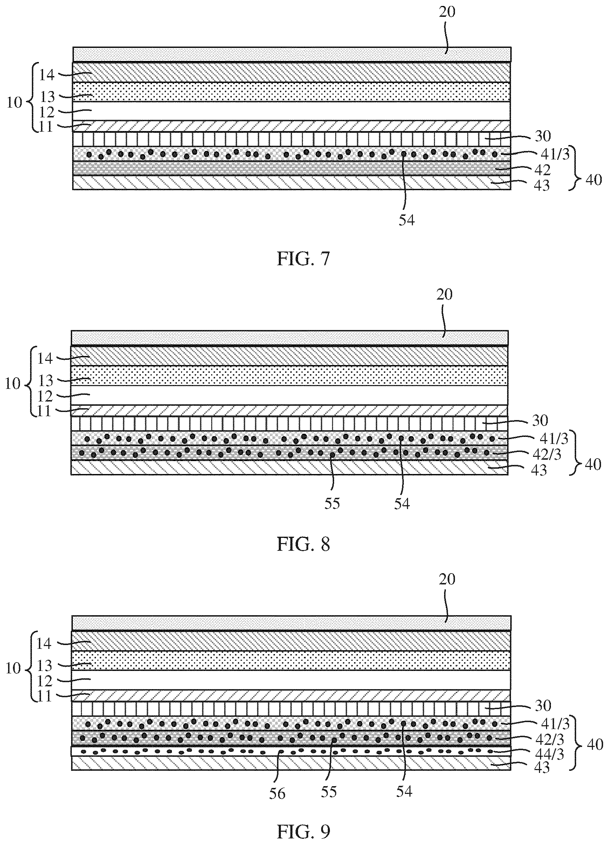

In an embodiment, FIG. 7 is a schematic diagram of another display assembly according to an embodiment of this application. As shown in FIG. 7, the display assembly includes a support film 30 and a heat dissipation film 40. The support film 30 is located on a side of a substrate 11 away from a display layer 13. The display layer 13 includes a plurality of light emitting devices. In other words, the support film 30 is located on a side of the substrate 11 away from the light emitting devices. The heat dissipation film 40 is located on a side of the support film 30 away from the substrate 11. The heat dissipation film 40 includes a reticulate adhesive layer 41, a foam layer 42, and a heat dissipation function layer 43 that are sequentially away from the support film 30. The reticulate adhesive layer 41 is doped with a conductive material 54, and the reticulate adhesive layer 41 is reused as an electrostatic dissipation layer 3. The conductive material 54 includes one or more of conductive materials such as 3,4-ethylenedioxythiophene monomer, PEDOT (a polymer of (3,4-ethylenedioxythiophene monomer)), fluorine, and phosphorus.

In the conventional technology, both a reticulate adhesive layer and a foam layer in a display panel are of non-conductive structures. However, in this embodiment of this application, the reticulate adhesive layer 41 is doped with the conductive material 54 to form a reticulate adhesive layer with low impedance, so that surface impedance of the reticulate adhesive layer 41 is not greater than E11 S2/sq. Therefore, charges on an interface of the support film 30 can be conducted into the reticulate adhesive layer 41, and the charges on the interface of the support film 30 can be quickly discharged, to avoid charge accumulation on the support film 30. In this way, charge accumulation on a back side of a display panel 10 is avoided, thereby avoiding a display fault caused by charge accumulation.

In some implementations, the heat dissipation function layer 43 is a copper foil layer. In some implementations, the heat dissipation function layer 43 is a graphene layer.

In another embodiment, FIG. 8 is a schematic diagram of another display assembly according to an embodiment of this application. As shown in FIG. 8, a reticulate adhesive layer 41 is doped with a conductive material 54, and the reticulate adhesive layer 41 is reused as an electrostatic dissipation layer 3. In addition, a foam layer 42 is doped with a conductive material 55, and the foam layer 42 is reused as an electrostatic dissipation layer 3. The conductive material 55 doped in the foam layer 42 may be the same as or different from the conductive material 54 doped in the reticulate adhesive layer 41. In this implementation, the reticulate adhesive layer 41 is doped with the conductive material 54 to form a reticulate adhesive layer with low impedance, and the foam layer 42 is doped with the conductive material 55 to form a low-impedance foam layer 42, so that surface impedance of the reticulate adhesive layer 41 and surface impedance of the foam layer 42 each are not greater than E11 Q/sq. Therefore, charges on an interface of a support film 30 can be conducted into the reticulate adhesive layer 41, and then the charges are conducted into the foam layer 42 through the reticulate adhesive layer 41, so that the charges on the interface of the support film 30 can be quickly discharged, to avoid charge accumulation on the support film 30. In this way, charge accumulation on a back side of a display panel 10 is avoided, thereby avoiding a display fault caused by charge accumulation.

In another embodiment, FIG. 9 is a schematic diagram of another display assembly according to an embodiment of this application. As shown in FIG. 9, a reticulate adhesive layer 41 is doped with a conductive material 54, and the reticulate adhesive layer 41 is reused as an electrostatic dissipation layer 3. In addition, a foam layer 42 is doped with a conductive material 55, and the foam layer 42 is reused as an electrostatic dissipation layer 3. A first adhesive layer 44 is further disposed between the foam layer 42 and a heat dissipation function layer 43. The first adhesive layer 44 is doped with a conductive material 56, and the first adhesive layer 44 is an electrostatic dissipation layer 3. In this implementation, the reticulate adhesive layer 41, the foam layer 42, and the first adhesive layer 44 between the foam layer 42 and the heat dissipation function layer 43 are all electrostatic dissipation layers with low impedance, and a path for discharging static electricity is formed on a back side of a display panel 10. Static electricity on an interface of a support layer 30 can be conducted into the reticulate adhesive layer 41, conducted into the foam layer 42 through the reticulate adhesive layer 41, conducted into the first adhesive layer 44 through the foam layer 42, and then conducted into the heat dissipation function layer 43 through the first adhesive layer 44. If the heat dissipation function layer 43 is a copper foil layer or a graphene layer, the heat dissipation function layer 43 has conductive performance. The heat dissipation function layer 43 is grounded or connected to a middle frame of an electronic device, so that electrostatic charges on the back side of the display panel 10 can be quickly discharged. In this way, charge accumulation on the back side of the display panel 10 is avoided, thereby avoiding a display fault caused by charge accumulation.

In an embodiment, the conductive material 56 doped in the first adhesive layer 44 and the conductive material 54 doped in the reticulate adhesive layer 41 are the same material. In another embodiment, the conductive material 56 doped in the first adhesive layer 44 and the conductive material 54 doped in the reticulate adhesive layer 41 are different materials.

In some implementations, the first adhesive layer 44 is a pressure-sensitive adhesive layer.

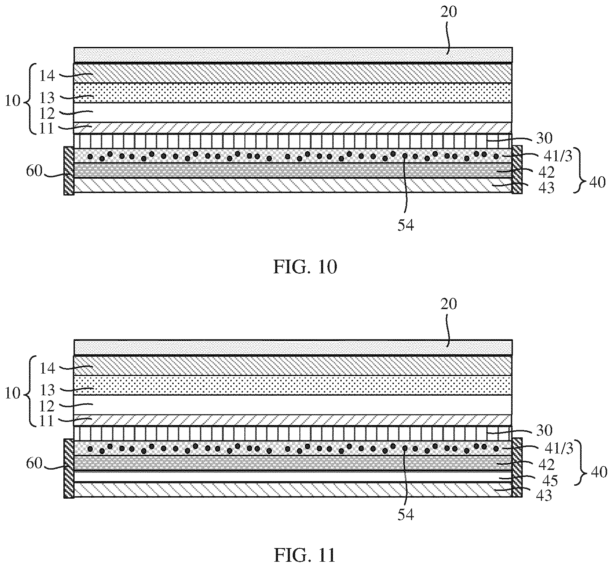

In another embodiment, FIG. 10 is a schematic diagram of another display assembly according to an embodiment of this application. As shown in FIG. 10, a reticulate adhesive layer 41 is doped with a conductive material 54, and the reticulate adhesive layer 41 is reused as an electrostatic dissipation layer 3. The display assembly further includes a first conductive structure 60, and the first conductive structure 60 covers at least a part of an end portion of a heat dissipation film 40. It may be understood that the heat dissipation film 40 is a film layer with a specific thickness, and the end portion of the heat dissipation film 40 is a peripheral edge portion of the film layer. The first conductive structure 60 extends from an end face of the reticulate adhesive layer 41 to an end face of a heat dissipation function layer 43. Each film layer has a specific thickness. It may be understood that an end face of the film layer is a side face of the film layer, and is also an edge of the film layer. In other words, the first conductive structure 60 extends from a side face of the reticulate adhesive layer 41 to a side face of the heat dissipation function layer 43. The first conductive structure 60 can implement a conductive path between the reticulate adhesive layer 41 and the heat dissipation function layer 43. In this implementation, a path that is for discharging static electricity and that can be formed on a back side of a display panel 10 is as follows: Static electricity on an interface of a support layer 30 can be conducted into the reticulate adhesive layer 41, and conducted into the heat dissipation function layer 43 by using the first conductive structure 60 covering the end face of the reticulate adhesive layer 41. The heat dissipation function layer 43 is grounded or connected to a middle frame of an electronic device, so that electrostatic charges on the back side of the display panel 10 can be quickly discharged. In this way, charge accumulation on the back side of the display panel 10 is avoided, thereby avoiding a display fault caused by charge accumulation.

In some implementations, the first conductive structure 60 is conductive liquid or a conductive adhesive, for example, a pressure-sensitive adhesive doped with a conductive material.

In some implementations, the first conductive structure 60 is a conductive fabric.

In another embodiment, based on the embodiment in FIG. 8, the first conductive structure 60 is disposed at at least a part of the end portion of the heat dissipation film 40, and the first conductive structure 60 extends from the end face of the reticulate adhesive layer 41 to the end face of the heat dissipation function layer 43. The first conductive structure 60 is a continuous structure, and the first conductive structure 60 also covers an end face of the foam layer 42. A conductive path between the reticulate adhesive layer 41 and the heat dissipation function layer 43 can be implemented by using the first conductive structure 60, and a conductive path between the low-impedance foam layer 42 and the heat dissipation function layer 43 can also be implemented.

In another embodiment, based on the embodiment in FIG. 9, the first conductive structure 60 is disposed at at least a part of the end portion of the heat dissipation film 40, and the first conductive structure 60 extends from the end face of the reticulate adhesive layer 41 to the end face of the heat dissipation function layer 43. The first conductive structure 60 is a continuous structure, and the first conductive structure 60 also covers an end face of the foam layer 42 and an end face of the first adhesive layer 44. In this implementation, a conductive path between the reticulate adhesive layer 41 and the heat dissipation function layer 43 can be implemented by using the first conductive structure 60, and a conductive path between the low-impedance foam layer 42 and the heat dissipation function layer 43 can also be implemented. In addition, static electricity conducted into the first adhesive layer 44 can not only be conducted into the heat dissipation function layer 43 on an interface on which the first adhesive layer 44 is in contact with the heat dissipation function layer 43, but also can be conducted into the heat dissipation function layer 43 through the end face of the first adhesive layer 44 by using the first conductive structure 60. This implementation can add a path for discharging static electricity, and this helps quickly discharge the static electricity on the back side of the display panel 10 away, and avoid electrostatic accumulation.

In some embodiments, FIG. 11 is a schematic diagram of another display assembly according to an embodiment of this application. As shown in FIG. 11, a heat dissipation film 40 further includes a polyimide film 45, and the polyimide film 45 is located between a heat dissipation function layer 43 and a foam layer 42. The polyimide film 45 has good thermal conductive performance, to improve a heat dissipation capability of the heat dissipation film 40, and ensure quick and uniform heat dissipation on a back side of a display panel. In this implementation, a path that is for discharging static electricity and that is formed on the back side of the display panel 10 is as follows: Static electricity on an interface of a support film 30 is conducted into a reticulate adhesive layer 41, and conducted into the heat dissipation function layer 43 by using a first conductive structure 60 covering an end face of a reticulate adhesive layer 41. In this case, the polyimide film 45 does not affect discharging of the static electricity on the back side of the display panel 10.

In addition, the heat dissipation film 40 in the embodiment of FIG. 10 may also include the polyimide film. This is not shown in the accompanying drawings.

In some implementations, an opening groove is provided on the heat dissipation film 40, the opening groove exposes a surface of the support film 30, and then a continuous conductive structure is coated on the exposed surface of the support film 30, a side wall of the opening groove, and a back side of the heat dissipation film 40 to form a path for discharging static electricity, so that static electricity on the support film 30 can be quickly discharged, thereby avoiding electrostatic accumulation on the support film 30. In this way, electrostatic charge accumulation on the back side of the display panel 10 can be avoided, and a display fault caused by electrostatic accumulation on the display panel 10 is avoided, thereby improving an anti-static capability of the display assembly. In addition, the anti-static capability of the display assembly is improved without removing an anti-fingerprint coating in the display assembly, thereby ensuring a display effect of the display assembly and a smooth touch feeling of a user.

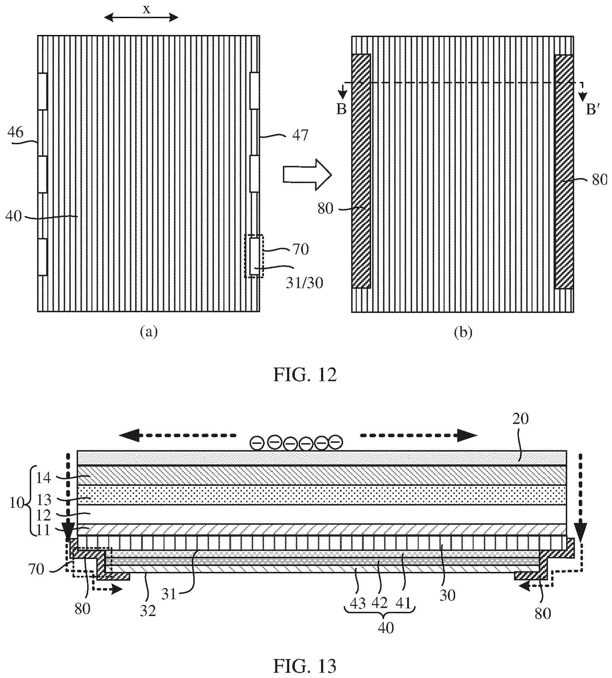

In an embodiment, FIG. 12 is a schematic diagram of another display assembly according to an embodiment of this application. FIG. 13 is a schematic cross sectional view of a position of a tangent B-B' in FIG. 12. FIG. 12 is a schematic diagram of viewing a side of a display panel 10 from a heat dissipation film 40 of the display assembly. To clearly show a structure of the heat dissipation film 40, a second conductive structure 80 is not shown in (a) in FIG. 12, and in (b) in FIG. 12, the second conductive structure 80 is coated at an end portion of the heat dissipation film 40 in a complete structure of the display assembly.

It can be seen from (a) in FIG. 12 that the heat dissipation film 40 has an opening groove 70, and the opening groove 70 penetrates the heat dissipation film 40 in a thickness direction of the heat dissipation film 40. The opening groove 70 exposes a surface of a support film 30. A surface on a side of the support film 30 away from a substrate 11 is a first surface 31. The opening groove 70 exposes the first surface 31. As shown in (a) in FIG. 12, the heat dissipation film 40 includes a first end portion 46 and a second end portion 47. In a first direction x, the first end portion 46 and the second end portion 47 are respectively located on two sides of the display assembly. It can be seen from (b) in FIG. 12 that second conductive structures 80 are coated on both the first end portion 46 and the second end portion 47 of the heat dissipation film 40.

As shown in FIG. 13, the surface on the side of the support film 30 away from the substrate 11 is the first surface 31. A surface on a side of the heat dissipation film 40 away from the support film 30 is a second surface 32. The second conductive structure 80 covers the first surface 31 and extends to cover a side wall of the opening groove 70 and at least a part of the second surface 32. The second conductive structure 80 is a continuous structure. The surface on the side of the heat dissipation film 40 away from the support film 30 is usually a surface of a heat dissipation function layer 43. In other words, the second conductive structure 80 covers at least a part of the surface of the heat dissipation function layer 43.

In the conventional technology, an edge of the display assembly is coated with conductive liquid, and the conductive liquid coated on end faces of the support film 30 and the heat dissipation film 40 is used as a path for discharging static electricity on a back side of the display panel. However, because both the support film 30 and the heat dissipation film 40 are thin, the conductive liquid is coated only on the end faces of the support film 30 and the heat dissipation film 40. In this case, a channel for discharging static electricity is narrow, and solidification cracking is likely to be caused, which results the support film 30 to be electrically disconnected to the heat dissipation film 40. Consequently, the static electricity cannot be conducted into the heat dissipation film 40 from the support film 30, and a problem of electrostatic accumulation on the back side of the display panel 10 cannot be improved.

In this implementation of this application, a conductive path between the first surface 31 of the support film 30 and the second surface 32 of the heat dissipation film 40 is formed by using the second conductive structure 80. Electrostatic charges on an interface of the support film 30 can be conducted into the second surface 32 of the heat dissipation film 40 by using the second conductive structure 80. With a design of the opening groove 70, the second conductive structure 80 not only covers a side face of the support film 30 and a side face of the heat dissipation film 40, but also extends into the opening groove 70 to cover the first surface 31 of the support film 30, and extends out of the side wall of the opening groove 70 to cover the second surface 32 of the heat dissipation film 40. The second conductive structure 80 covers the first surface 31 of the support film 30, and a contact area between the second conductive structure 80 and the support film 30 is large. In addition, the second conductive structure 80 covers at least a part of the second surface 32, and a contact area between the second conductive structure 80 and the heat dissipation function layer 43 is also large. With the design of the opening groove 70, the contact area between the second conductive structure 80 and the support film 30 is increased, and a contact area between the second conductive structure 80 and the heat dissipation film 40 is also increased, so that a conductive channel between the support film 30 and the second conductive structure 80 is wider, and a capability for discharging static electricity can be enhanced. In this way, the static electricity on the back side of the display panel 10 can be quickly discharged by using the second conductive structure 80, thereby avoiding electrostatic accumulation on the back side of the display panel 10.

As shown in (b) in FIG. 12, the second conductive structure 80 is not only disposed at a position of the opening groove 70, but forms a continuous structure in an extension direction of the edge of the display assembly. In this way, contact areas between the second conductive structure 80 and the end face of the support film 30 and between the second conductive structure 80 and the end face of the heat dissipation film 40 can be increased.

In some implementations, the second conductive structure 80 is disposed at the position of the opening groove 70, and second conductive structures 80 at positions of adjacent opening grooves 70 are not connected. This is not shown in the accompanying drawings.

In addition, as shown in (b) in FIG. 12, the second conductive structures 80 are disposed on left and right edges of the display assembly. In some implementations, conductive structures are also disposed on upper and lower edges of the display assembly.

In addition, with the design of the opening groove 70, three surfaces including the first surface 31 of the support film 30, the side wall (which is equivalent to the side face of the heat dissipation film 40) of the opening groove 70, and the second surface 32 of the heat dissipation film 40 are connected by using the second conductive structure 80, and an overall connection effect is good. In addition, both contact areas between the second conductive structure 80 and the first surface 31 and between the second conductive structure 80 and the second surface 32 are large, so that a problem that a conductive path is blocked due to solidification cracking caused by the conductive liquid being coated only on the end faces of the support film 30 and the heat dissipation film 40 can be avoided.

As shown in (a) in FIG. 12, a part of the end portion of the heat dissipation film 40 is recessed to the inside of the heat dissipation film 40 to form the opening groove 70. That is, the opening groove 70 is provided on a peripheral edge of the heat dissipation film 40. The first end portion 46 and the second end portion 47 may also be referred to as a first edge and a second edge of the heat dissipation film 40. A process for forming the opening groove at the edge of the heat dissipation film is simple, a range in which the second conductive structure can be disposed is large, and an overall structure of the display assembly is slightly affected.

In some implementations, a quantity of opening grooves 70 formed at the first end portion 46 is equal to a quantity of opening grooves 70 formed at the second end portion 47. It is beneficial to balance capabilities for discharging static electricity at various positions of the back side of the display panel and avoid local electrostatic accumulation.

As shown in (a) in FIG. 12, opening grooves 70 are provided on left and right sides of the heat dissipation film 40. In some implementations, the opening groove is also provided on at least one of upper and lower sides of the heat dissipation film 40.

As shown in (a) in FIG. 12, three opening grooves 70 are formed at the first end portion 46. It should be noted that, a quantity of opening grooves 70 provided in the heat dissipation film 40 is not specifically limited in this embodiment of the present invention.

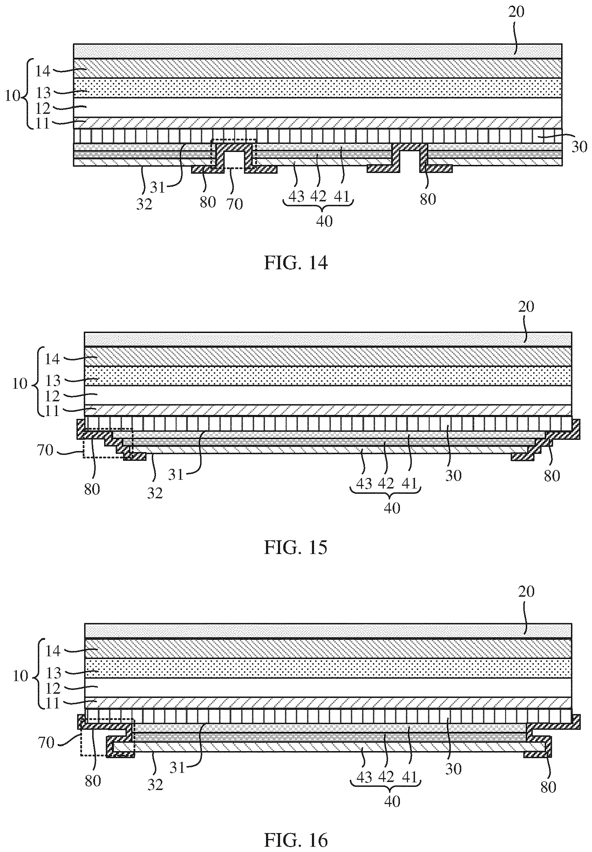

In some implementations, FIG. 14 is a schematic diagram of another display assembly according to an embodiment of this application. As shown in FIG. 14, an opening groove 70 is located inside a heat dissipation film 40. In other words, the opening groove 70 is not located on a peripheral edge of the heat dissipation film 40. The opening groove 70 penetrates the heat dissipation film 40 in a thickness direction of the heat dissipation film 40, and the opening groove 70 exposes a first surface 31 of a support film 30. A second conductive structure 80 covers the first surface 31 and extends to cover a side wall of the opening groove 70 and at least a part of a second surface 32. In this implementation, a conductive path between the first surface 31 of the support film 30 and the second surface 32 of the heat dissipation film 40 is formed by using the second conductive structure 80.

In some implementations, as shown in FIG. 13, at a position of the opening groove 70, end faces of a reticulate adhesive layer 41, a foam layer 42, and a heat dissipation function layer 43 are flush. In this way, a process for forming the opening groove 70 of the heat dissipation film 40 is relatively simple.

In another embodiment, FIG. 15 is a schematic diagram of another display assembly according to an embodiment of this application. As shown in FIG. 15, at a position of an opening groove 70, an end face of a foam layer 42 extends out of an end face of a heat dissipation function layer 43, and an end face of a reticulate adhesive layer 41 extends out of the end face of the foam layer 42. On a side wall of the opening groove 70, the end face of the reticulate adhesive layer 41 and the end face of the foam layer 42 are misplaced to form a step, and the end face of the foam layer 42 and the end face of the heat dissipation function layer 43 are misplaced to form a step. In this way, when a second conductive structure 80 is coated at a side wall position of the opening groove 70, it can be ensured that the second conductive structure 80 extends from a first surface 31 to a second surface 32 in a relatively smooth way, to improve reliability of covering the side wall of the opening groove 70 by the second conductive structure 80.

In another embodiment, FIG. 16 is a schematic diagram of another display assembly according to an embodiment of this application. As shown in FIG. 16, at a position of an opening groove 70, an end face of a reticulate adhesive layer 41 is basically flush with an end face of a foam layer 42, and an end face of a heat dissipation function layer 43 extends out of the end face of the foam layer 42. A second conductive structure 80 covers a first surface 31, extends to cover the end face of the reticulate adhesive layer 41 and the end face of the foam layer 42 in the opening groove 70, and extends to cover at least a part of a surface on a side of the heat dissipation function layer 43 close to the foam layer 42, the end face of the heat dissipation function layer 43, and at least a part of a second surface 32.

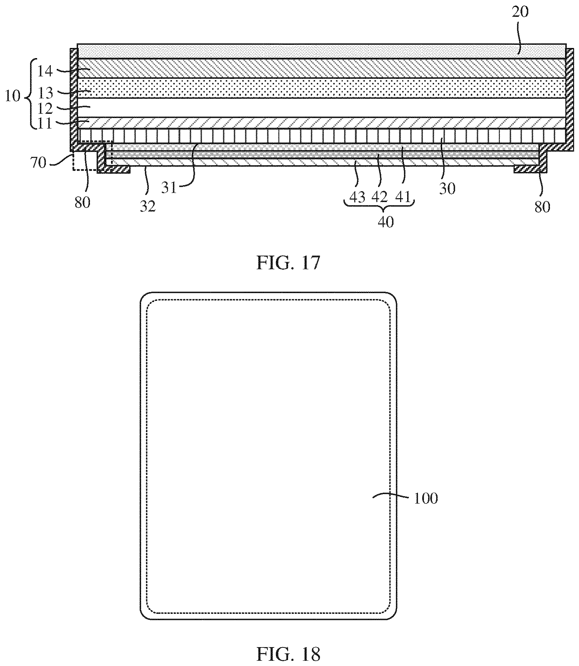

In another embodiment, FIG. 17 is a schematic diagram of another display assembly according to an embodiment of this application. As shown in FIG. 17, a second conductive structure 80 is a continuous structure, and the second conductive structure 80 further extends from a first surface 31 to cover an end face of a display panel 10 and an end face of a cover plate 20. The second conductive structure 80 can implement a conductive path between the cover plate 20 and a heat dissipation film 40, and electrostatic charges generated on a surface of the cover plate 20 due to friction can be directly conducted into the heat dissipation film 40 by using the second conductive structure 80, to avoid electrostatic accumulation caused by transmission of static electricity to a back side of the display panel 10.

In some implementations, in the foregoing implementations in FIG. 13 to FIG. 17, the heat dissipation film 40 further includes a polyimide film layer, and the polyimide film layer is located between the heat dissipation function layer 43 and the foam layer 42. This is not shown in the accompanying drawings.

An embodiment of this application further provides an electronic device. FIG. 18 is a schematic diagram of the electronic device according to an embodiment of this application. As shown in FIG. 18, the electronic device includes a display assembly 100 provided in any embodiment of this application. A structure of the display assembly 100 has been described in the foregoing related embodiments, and details are not described herein again. The electronic device provided in this embodiment of this application may be an electronic device like a mobile phone, a tablet, a notebook computer, a television, or an intelligent wearable device.

## Claims

1. A display assembly, wherein the display assembly comprises:
a display panel, wherein the display panel comprises a substrate and a plurality of light emitting devices located on a side of the substrate;
a polarizer, wherein the polarizer is located on a side of the light emitting device away from the substrate; and
a heat dissipation film, wherein the heat dissipation film is located on a side of the display panel away from the polarizer, wherein
the polarizer comprises at least one electrostatic dissipation layer, or the heat dissipation film comprises at least one electrostatic dissipation layer; and the electrostatic dissipation layer is configured to guide static electricity into the electrostatic dissipation layer.

2. The display assembly of claim 1, wherein
surface impedance of the electrostatic dissipation layer is Z, wherein Z≤E11 S2/sq.

3. The display assembly of claim 1, wherein
the polarizer comprises a polarizing function layer and a pressure-sensitive adhesive layer, and at least one pressure-sensitive adhesive layer is doped with a conductive material, and is used as the electrostatic dissipation layer.

4. The display assembly of claim 1, wherein
the polarizer comprises a polarizing function layer and a pressure-sensitive adhesive layer, and the electrostatic dissipation layer is located between the polarizing function layer and the pressure-sensitive adhesive layer.

5. The display assembly of claim 1, wherein
the heat dissipation film comprises a reticulate adhesive layer, a foam layer, and a heat dissipation function layer that are successively away from the display panel; and
the reticulate adhesive layer is doped with a conductive material, and the reticulate adhesive layer is used as the electrostatic dissipation layer.

6. The display assembly of claim 5, wherein
the foam layer is doped with a conductive material, and the foam layer is used as the electrostatic dissipation layer.

7. The display assembly of claim 6, wherein
a first adhesive layer is further disposed between the foam layer and the heat dissipation function layer, the first adhesive layer is doped with a conductive material, and the first adhesive layer is used as the electrostatic dissipation layer.

8. The display assembly of claim 5, wherein
the display assembly further comprises a first conductive structure, the first conductive structure covers at least a part of an end portion of the heat dissipation film, and the first conductive structure extends from an end face of the reticulate adhesive layer to an end face of the heat dissipation function layer.

9. A display assembly, wherein the display assembly comprises:
a display panel, wherein the display panel comprises a substrate and a plurality of light emitting devices located on a side of the substrate;
a support film, wherein the support film is located on a side of the substrate away from the light emitting device, and a surface on a side of the support film away from the substrate is a first surface; and
a heat dissipation film, wherein the heat dissipation film is located on the side of the support film away from the substrate, a surface on a side of the heat dissipation film away from the support film is a second surface, the heat dissipation film has an opening groove, and the opening groove exposes the first surface, wherein
the display assembly further comprises a second conductive structure, and the second conductive structure covers the first surface and extends to cover a side wall of the opening groove and at least a part of the second surface.

10. The display assembly of claim 9, wherein
a part of an edge of the heat dissipation film is recessed to the inside of the heat dissipation film to form the opening groove.

11. The display assembly of claim 10, wherein
the heat dissipation film comprises a first end portion and a second end portion; in a first direction, the first end portion and the second end portion are respectively located on two sides of the display assembly; and
a quantity of opening grooves formed at the first end portion is equal to a quantity of opening grooves formed at the second end portion.

12. The display assembly of claim 10, wherein
the display assembly further comprises a cover plate, and the cover plate is located on a side of the display panel away from the support film; and
the second conductive structure further extends from the first surface to cover an end face of the display panel and an end face of the cover plate.

13. The display assembly of claim 9, wherein
the heat dissipation film comprises a reticulate adhesive layer, a foam layer, and a heat dissipation function layer that are successively away from the support film; and
at a position of the opening groove, end faces of the reticulate adhesive layer, the foam layer, and the heat dissipation function layer are flush.

14. The display assembly of claim 9, wherein
the heat dissipation film comprises a reticulate adhesive layer, a foam layer, and a heat dissipation function layer that are successively away from the support film; and
at a position of the opening groove, an end face of the foam layer extends out of an end face of the heat dissipation function layer, and an end face of the reticulate adhesive layer extends out of the end face of the foam layer.

15. The display assembly of claim 9, wherein
the heat dissipation film comprises a reticulate adhesive layer, a foam layer, and a heat dissipation function layer that are successively away from the support film; and
at a position of the opening groove, an end face of the reticulate adhesive layer is flush with an end face of the foam layer, and an end face of the heat dissipation function layer extends out of the end face of the foam layer.

16. An electronic device, comprising the display assembly of any one of claims 1 to 15.
